## Europäisches Patentamt

## European Patent Office

## Office européen des brevets

(19)

(11) Numéro de publication: **0 161 166**
**B1**

(12) **FASCICULE DE BREVET EUROPÉEN**

(45) Date de publication du fascicule du brevet:
**20.07.88**

(51) Int. Cl.⁴: **H 01 L 23/56, H 03 B 9/14**

(21) Numéro de dépôt: **85400705.1**

(22) Date de dépôt: **09.04.85**

(54) Combineur compact de dispositifs semi-conducteurs, fonctionnant en hyperfréquences.

(30) Priorité: **13.04.84 FR 8405905**

(43) Date de publication de la demande:
**13.11.85 Bulletin 85/46**

(45) Mention de la délivrance du brevet:
**20.07.88 Bulletin 88/29**

(84) Etats contractants désignés:
**DE GB IT NL**

(56) Documents cité:
**EP-A-0 001 890
EP-A-0 104 995
FR-A-2 377 137
US-A-4 042 952
US-A-4 172 261
US-A-4 200 880**

**MICROWAVE JOURNAL, vol. 22, no. 1, janvier 1979, pages 63-68, Dedham, US; R. TENENHOLTZ: "Designing megawatt diode duplexers"**

(73) Titulaire: **THOMSON- CSF, 173, Boulevard Haussmann, F-75379 Paris Cédex 08 (FR)**

(72) Inventeur: **Bert, Alain, THOMSON- CSF SCPI 173, bld Haussman, F-75379 Paris Cedex 08 (FR)**
Inventeur: **Mamodaly, Narguisse, THOMSON- CSF SCPI 173, bld Haussman, F-75379 Paris Cedex 08 (FR)**

(74) Mandataire: **Taboureau, James, THOMSON- CSF SCPI 19, avenue de Messine, F-75008 Paris (FR)**

## Description

La présente invention concerne un combineur compact de dispositifs semiconducteurs, fonctionnant en hyperfréquence, dans la gamme des ondes millimétriques telle que la bande K par exemple de 11 à 33 GHz.

La puissance disponible sur la sortie de ce combineur est obtenue au moyen d'au moins un dispositif semiconducteur, préadapté en impédance par une cellule à deux selfs et deux capacités: l'une de ces capacités est formée par un anneau céramique métallisé sur deux faces opposées et formant une partie du boîtier d'encapsulation du combineur.

Le combineur selon l'invention est un composant qui entre dans la réalisation de systèmes plus complexes tels qu'oscillateurs ou amplificateurs, et il regroupe des éléments à résistances négatives, telles que des diodes à avalanche ou diodes Gunn ou Impatt.

L'objet de l'invention est de disposer de puissances très élevées, compte tenu des fréquences considérées, c'est-à-dire plusieurs dizaines de watts moyens ou plusieurs centaines de watts crête. Or l'on sait qu'aux fréquences millimétriques, les pastilles des dispositifs semiconducteurs sont très petites, en raison même de leur fréquence de travail, et de ce fait elles ne dissipent qu'une faible puissance. Il est donc nécessaire, pour obtenir une puissance de sortie plus élevée, de combiner plusieurs pastilles de semiconducteurs ou d'adapter un dispositif qui, sur une seule pastille, regroupe l'équivalent de plusieurs petites pastilles, avec la préadaptation nécessaire.

Des combineurs sont connus, en particulier des demandes de brevet français N° 79.08790 et N° 82.16296 déposées par la Demanderesse. Dans le premier des documents cités, le combineur allie des dispositifs semiconducteurs montés en parallèle et préadaptés par des lignes micro-bandes déposées sur un substrat. La configuration de ce combineur rappelle celle d'un circuit réalisé sur substrat plat, tels que les circuits imprimés, et elle est - toute proportion gardée - trop encombrante en raison des lignes micro-bandes dont la longueur est égale au quart ou à la moitié de la longueur d'onde correspondant à la fréquence de travail. C'est pourquoi, dans le second document cité, le combineur est monté dans un boîtier classique, cylindrique, et prévu pour encapsuler normalement une pastille de dispositif semiconducteur, mais le substrat qui porte les pastilles est en matériau diélectrique dont la constante diélectrique est choisie pour que les lignes micro-bandes puissent être repliées et disposées de façon sensiblement concentrique aux pastilles, regroupées au centre du boîtier. Il y a donc un gain de place, bien que ce combineur utilise encore des micro-bandes.

Le combineur selon l'invention regroupe plusieurs pastilles semiconductrices montées en parallèle, ou une seule pastille assurant la même fonction que plusieurs pastilles qui ne sont pas séparées, dans une configuration assurant la transformation d'impédance. L'adaptation d'impédance est obtenue au moyen d'une double cellule L-C, pour chaque dispositif semiconducteur, les selfs L étant constituées par les fils ou rubans de liaison entre la pastille et les condensateurs C, dont l'un est un condensateur en élément localisé, ou pavé, et l'autre est constitué par une couronne de matériau diélectrique, métallisée sur deux faces opposées: cette couronne, placée entre l'embase métallique et le couvercle métallique par lequel est amenée la tension de polarisation, constitue le boîtier d'encapsulation du combineur. Ce système de préadaptation est plus compact qu'un système à micro-bandes, et il permet d'accueillir, dans un boîtier donné, des pastilles semiconductrices plus importantes que s'il n'y avait pas de préadaptation, donc il permet d'émettre plus de puissance.

De façon plus précise, l'invention concerne un combineur compact de dispositifs semiconducteurs, fonctionnant en hyperfréquences, comportant, fixées sur une embase métallique, au moins une pastille semiconductrice et au moins une cellule de préadaptation d'impédance formée par deux selfs en série et deux capacités en parallèle, chaque capacité étant connectée entre une self et la masse, ce combineur étant caractérisé en ce que:
- la première capacité de chaque cellule de préadaptation d'impédance est un élément localisé, en pavé, fixé sur l'embase,
- la seconde capacité commune à toutes les cellules de préadaptation d'impédance est un élément localisé, formé par une couronne, en matériau diélectrique métallisé sur deux faces planes opposées, fixé sur l'embase et concentrique au combineur,
- les selfs sont en éléments non localisés, formées par des rubans métalliques thermocomprimés entre une pastille et la première capacité pour la première self, entre la première et la seconde capacité pour la seconde self.

L'invention sera mieux comprise par la description suivante de deux exemples de réalisation d'un combineur, cette description s'appuyant sur les figures jointes en annexe qui représentent:
- figure 1: schéma électrique d'un combineur selon l'invention,
- figure 2: plan de montage d'un combineur selon l'invention dans une première réalisation,
- figure 3: plan de montage d'un combineur selon l'invention, dans une deuxième réalisation,
- figure 4: vue en plan d'un combineur selon l'invention, conforme à la figure 2,
- figure 5: vue en plan d'un combineur selon l'invention, conforme à la figure 3,
- figure 6: vue en coupe d'un combineur selon l'invention,
- figure 7: vue de trois quart dans l'espace d'une variante du combineur selon l'invention dans laquelle les éléments semiconducteurs des capacités sont intégrés chacun en une couronne.

Pour obtenir avec des composants à l'état solide, des puissances de l'ordre de plusieurs dizaines de watts moyens, il faut envisager une combinaison alliant plusieurs composants. Il existe plusieurs façons de procéder. Soit la combinaison de plusieurs pastilles encapsulées hors boîtier, telles que par exemple des combinaisons de type Kurokawa ou Braddock Hodges, dans lesquelles l'énergie émise par des pastilles séparées est concentrée au moyen de guides d'ondes, speciaux ou à deux dimensions. Soit une combinaison au niveau des pastilles que l'on peut considérer sous les deux formes suivantes:

- association de plusieurs pastilles de surface S' chacune, la surface globale équivalente étant alors S = n S', n étant le nombre de pastilles associées. Ce genre d'association peut se faire par exemple en découpant des pastilles non plus de façon unitaire mais groupées quatre par quatre, ce qui donne quatre dispositifs semiconducteurs côte à côte sur une seule pastille,

- utilisation d'une seule pastille de surface S équivalente à la surface qui vient d'être définie précédemment, mais cette pastille étant d'une forme adaptée, selon laquelle les dispositifs semiconducteurs sont regroupés en un seul dispositif semiconducteur équivalent. Par exemple, au lieu d'avoir quatre diodes réalisées côte à côte sur une même pastille, n'avoir plus qu'une seule diode de forme annulaire, la surface de l'anneau étant équivalente à la surface des quatre diodes précédentes. L'avantage de l'utilisation d'une seule pastille est que la résistance thermique du dispositif semiconducteur dépend du rayon moyen, s'il s'agit d'une diode annulaire par exemple.

Au niveau de la pastille, il n'est pas envisageable de trop augmenter la surface, pour augmenter l'énergie disponible. Il y a a cela deux raisons.

La première raison est que l'adaptation d'un dispositif semiconducteur devient plus délicate au fur et à mesure que croît la surface de ce dispositif semiconducteur. En effet l'impédance d'une diode à avalanche est faible et inversement proportionnelle à sa surface. Plus la surface croît, plus l'impédance de la diode diminue et plus le circuit extérieur doit ramener une impédance faible.

La seconde raison est que la notion de rendement identique entre une pluralité de pastilles et une pastille regroupant plusieurs dispositifs semiconducteuts n'est pas satisfaite. Pour conserver un même rendement, il faut augmenter le courant de polarisation, ce qui conduit à un échauffement au voisinage de la jonction. Cet échauffement se traduit par une élévation de la température de jonction, température proportionnelle au produit de la puissance appliquée par la résistance thermique, laquelle ne diminue pas de moitié par exemple lorsque la surface double. Au-delà d'une certaine surface, il n'est donc plus possible de conserver un rendement identique sans modifier la topologie de la diode. L'une des solutions, qui a déjà été citée et qui sera expliquée plus en détail ultérieurement, consiste à adopter une topologie annulaire. L'amélioration de la résistance thermique se fait alors en jouant sur la surface totale et sur le diamètre moyen de l'anneau.

Au niveau du boîtier regroupant une pluralité de pastilles, trois schémas de combinaison peuvent être envisagés:

- association de plusieurs pastilles en série ou en parallèle,

- addition d'une pluralité de dispositifs semiconducteurs réalisés sous forme "intégrée", à l'aide d'une pastille de topologie différente et de surface plus grande. C'est le cas de la diode annulaire qui vient d'être citée.

En ce qui concerne la mise en série d'une pluralité de diodes, des résultats significatifs ont été obtenus en laboratoire, en mettant en série quatre pastilles rapportées sur un support de diamant. La technique en reste complexe et les tentatives de simplification se heurtent à des limitations de performances.

Le schéma le plus intéressant, et qui est celui mis en oeuvre par le combineur selon l'invention, reste l'association d'une pluralité de dispositifs semiconducteurs montés en parallèle ou additionnes sous forme intégrée sur une seule pastille. Dans ce cas un dispositif assure la transformation d'impédance nécessaire pour adapter le combineur à son environnement dans un système plus complexe et pour équilibrer les puissances émises par chaque pastille. Ce dispositif peut être conçu soit à l'aide d'éléments non localisés, tels que par exemple les selfs présentées par des lignes de connexion, soit à l'aide d'éléments localisés, qui sont essentiellement les pastilles sur ou dans lesquelles sont réalisés des dispositifs semiconducteurs ou des capacités.

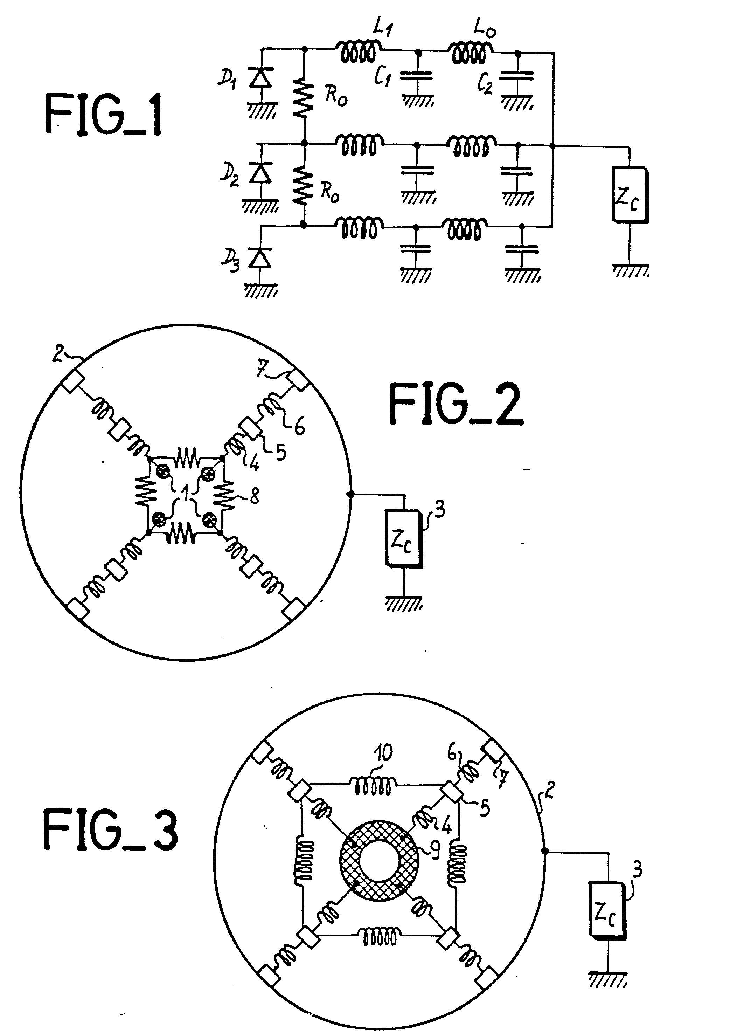

C'est ce que représente le schéma de la figure 1, qui correspond au schéma électrique du combineur selon l'invention. Une pluralité de diodes $D_1$, $D_2$, $D_3$ sont branchées en parallèle pour débiter leur énergie sur une charge d'impédance $Z_C$. Toutefois, afin d'équilibrer les puissances disponibles, et en raison des légères variations qui peuvent exister entre les caractéristiques des diodes $D_1$, $D_2$, $D_3$ ... des résistances d'équilibrage $R_0$ sont montées entre les cathodes de ces diodes. Chacune des diodes est reliée à la charge d'impédance $Z_C$ par une cellule de préadaptation en impédance, cette cellule étant elle-même constituée par deux réseaux $L_C$ montés en cascade, les selfs $L_1$ et $L_2$ étant montées en série, les capacités $C_1$ et $C_2$ branchées en parallèle entre les selfs $L_1$ et $L_2$ et la masse.

Les résistances $R_0$ incorporées dans ce schéma électrique ont pour objet d'éviter les oscillations sur les modes dissymétriques, ou leur incidence néfaste sur le fonctionnement du combineur sur le mode principal. Cependant elles sont "transparentes" pour le mode symétrique et ce montage, selon le schéma électrique de la figure 1 se comporte de la même façon que si une pluralité de diodes était connectée en parallèle aux bornes d'une unique cellule de préadaptation branchée sur la charge de sortie.

Connaissant l'impédance des diodes, et celle ramenée par le circuit extérieur $Z_C$, il est possible de calculer le rapport de transformation que doivent réaliser les cellules de préadaptation d'impédances, c'est-à-dire la transformation d'une basse impédance en une haute impédance. C'est à partir de ce rapport de transformation que sont calculées les valeurs des éléments localisés des cellules, c'est-à-dire essentiellement les valeurs des capacités $C_1$ et $C_2$. Les selfs sont réalisées au moyen des fils ou des rubans de liaison, et leur valeur est imposée, dans une certaine fourchette, par les dimensions du dispositif combineur. Ce sont donc préférentiellement les valeurs des capacités $C_1$ et $C_2$ qui sont calculées pour être adaptées au combineur.

L'invention à proprement parler concerne une topologie de réalisation, qui permet l'association de plusieurs diodes ou l'intégration d'une diode de forme différente et de surface équivalente de façon à construire un combineur dans un boîtier compact.

La figure 2 représente le plan de montage d'un combineur selon l'invention, dans une première réalisation. Ce combineur regroupe une pluralité de pastilles semiconductrices 1. Ces diodes sont au nombre de quatre sur la figure 2, mais ce n'est là qu'un exemple qui ne saurait en aucun cas limiter la portée de l'invention ou le nombre de dispositifs semiconducteurs regroupés dans le combineur. Ces diodes sont branchées en parallèle sur un collecteur d'énergie 2, qui est lui-même réuni à la charge extérieure 3, d'impédance $Z_C$. Chacune des diodes est reliée au collecteur d'énergie 2 par l'intermédiaire d'une cellule composée d'une première self 4 et un premier condensateur 5 en série avec une seconde self 6 et un second condensateur 7. Des résistances d'équilibrage 8 peuvent être montées entre les diodes, mais ceci ne constitue pas une obligation, seulement une variante au cas où les diodes ne présenteraient pas de caractéristiques suffisamment équilibrées entre elles.

Les pastilles de diodes sont représentées sous forme de cercle sur cette figure 2: c'est une représentation simplifiée des diodes découpées dans une plaquette de matériau semiconducteur, sur laquelle elles ont été fabriquées collectivement. Ces diodes peuvent être rapportées séparément sur une embase, qui n'est pas représentée sur cette figure 2, ou découpées collectivement et ne former qu'une seule pastille. Autour du groupe central formé sur l'embase par la pluralité des pastilles de diodes sont fixés une pluralité de pavés de condensateurs 5 qui sont réunis aux diodes par des fils ou par des rubans 4. Les secondes capacités 7, à raison d'une capacité par cellule de préadaptation sont en fait réalisées de façon collective sous la forme d'un anneau de céramique, plus exactement d'un anneau de matériau diélectrique qui constitue une partie du boîtier d'encapsulation du combineur. Cet anneau de matériau diélectrique, sur lequel on reviendra ultérieurement, est métallisé sur deux faces opposées et parallèles au plan de substrat: les deux métallisations et le matériau diélectrique forment ainsi un condensateur. En outre les métallisations servent à souder l'anneau d'une part sur l'embase, d'autre part sur le couvercle.

La figure 3 représente une seconde réalisation du plan de montage d'un combineur selon l'invention. Dans cette seconde réalisation la pluralité de diodes, telle que représentée par la première réalisation de la figure 2, est remplacée par ce que l'on pourrait appeler un circuit intégré de diode, c'est-à-dire une seule pastille de diode 9 de surface équivalente à la somme des surfaces des diodes élémentaires 1. La différence est que le diamètre moyen de l'anneau diffusé dans cette pastille pour former l'unique diode est plus grand que le diamètre moyen des diodes élémentaires 1, ce qui permet de mieux dissiper la chaleur. A partir de cette pastille unique, les circuits de préadaptation en impédance sont les mêmes, c'est-à-dire que chaque circuit comporte une self 4 et une capacité 5 en cascade avec une self 6 et une capacité 7.

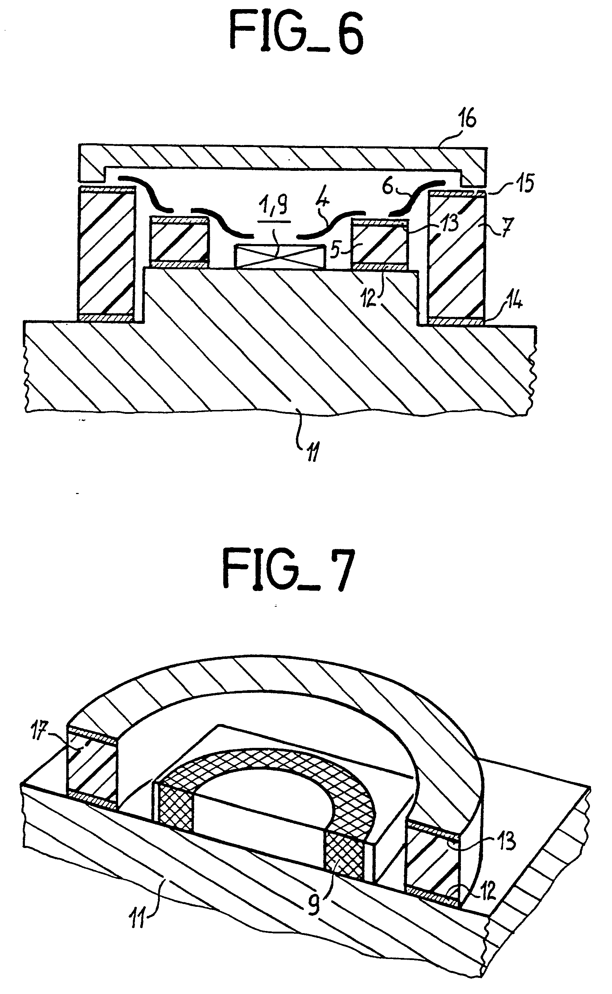

Toutefois dans le cas de la figure 3 où une pluralité de diodes discrètes sont réunies en une unique diode équivalente intégrée et circulaire, les capacités 5 peuvent également elles aussi être réunies en une unique capacité 5 circulaire comme cela sera montré plus loin en figure 7.

Du fait que la pluralité des diodes élémentaires 1 est remplacée par une unique diode annulaire 9, il n'est plus nécessaire, ou du moins utile dans certains cas, de disposer de résistances d'équilibrage 8 comme dans le cas de figure précédente. Cependant, et en fonction de la forme de réalisation, il peut être utile de réunir les capacités 5 par des liaisons électriques sous forme de fils par exemple de façon à répartir les potentiels de ces capacités. En effet, si les points de contact des selfs 4 ne sont pas répartis de façon régulière sur l'unique pastille 9, il peut arriver que les potentiels des armatures des capacités 5 ne soient pas identiques.

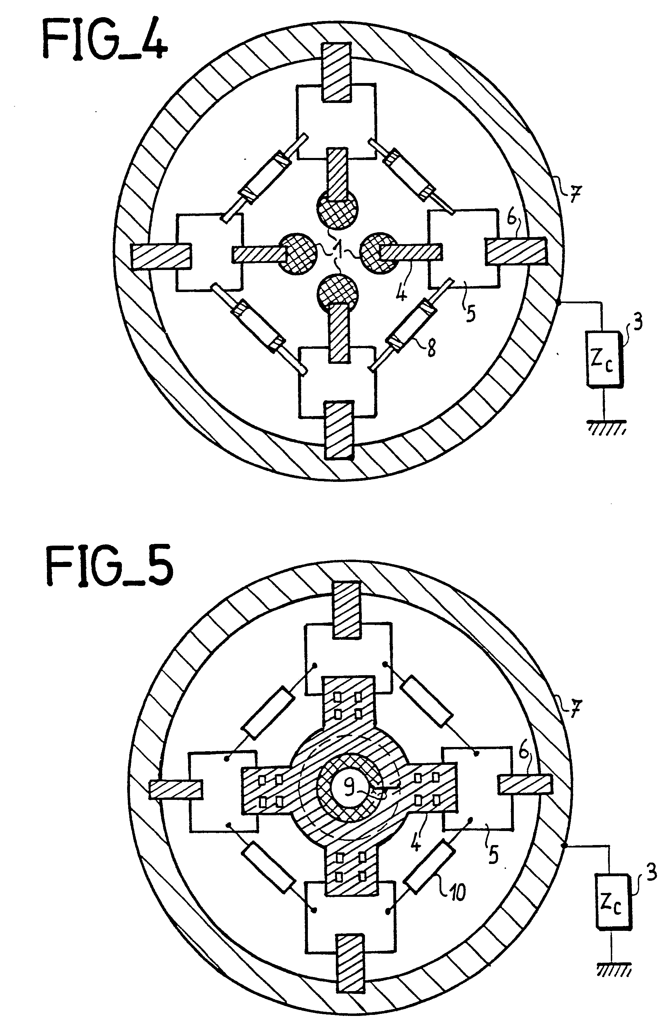

Les figures 4 et 5 représentent deux vues en plan, plus détaillées, des schémas d'implantation des figures 2 et 3 respectivement. Cependant, dans le but de faciliter la lecture de ces figures 4 et 5, les différents substrats et supports sur lesquels sont fixés les composants du combineur ont été supprimés du dessin et ils apparaissent en figure 6.

La figure 4 correspond donc à une vue en plan de l'implantation de composants unitaires, conformément à la figure 2. Un certain nombre de pastilles semiconductrices 1 - il y en a quatre sur la figure mais ceci ne constitue pas une limitation à la portée de l'invention - sont fixées au centre d'un dispositif circulaire, limité sur son pourtour par une couronne de matériau diélectrique 7. Entre les pastilles semiconductrices 1 et la couronne de matériau diélectrique 7 qui forme une partie du boîtier d'encapsulation sont fixés autant de capacités en pavé unitaire 5 qu'il y a de pastilles semiconductrices 1. Chaque pastille 1 est reliée à chaque capacité 5 par un fil ou préférablement en haute fréquence par un ruban métallique 4, formant self. Chaque capacité 5 est reliée à la couronne extérieure 7 par un fil ou par un ruban 6 formant self.

Le dispositif peut fonctionner tel qu'il vient d'être décrit, cependant il est préférable pour équilibrer les puissances de disposer entre les métallisations des capacités 5 des éléments résistifs 8, qui sont généralement des couches métalliques déposées sur un substrat céramique.

La description d'un combineur tel que celui de la figure 4 sera complétée ultérieurement par la figure 6.

La figure 5 représente une seconde réalisation du combineur selon l'invention dans le cas où, comme en figure 3, les pastilles semiconductrices ont été intégrées en une seule pastille 9 de surface équivalente.

La pastille 9 étant fixée au centre d'un support de forme circulaire, des capacités 5 sont fixées régulièrement autour de cette pastille centrale, comme s'il s'agissait d'une pluralité de pastilles semiconductrices élémentaires 1, pour répartir l'énergie; une capacité 7 en forme de couronne de matériau diélectrique est fixée concentriquement à la pastille circulaire 9, et elle sert de boîtier d'encapsulation au combineur.

Entre la pastille annulaire 9 et les capacités 5, la liaison électrique et les selfs correspondantes 4 sont assurées soit par des rubans comme dans le cas de la figure 4 soit par une pièce prédécoupée en forme de croix telle que représentée sur cette figure 5. Une telle pièce à l'avantage d'assurer une meilleure prise de contact avec la pastille annulaire 9, et les bras de la croix sont avantageusement découpés pour donner une certaine souplesse qui permet de les thermosouder plus facilement sur la pastille d'une part et sur la capacité 5 d'autre part. Le fait que ces bras soient perforés et se présentent sous forme de grille permet, une fois que le combineur est assemblé, d'ajuster sa fréquence par attaque chimique de la pastille.

Entre les pavés de capacités 5 et la capacité circulaire 7 les selfs sont assurées par des rubans métalliques 6, comme dans le cas de la figure précédente.

Etant donné que la pluralité de pastilles élémentaires 1 est remplacée dans le présent cas de figure par une unique pastille 9, il n'y a plus de différence possible entre les caractéristiques des pastilles. Par conséquent les résistances d'équilibrage 8 disposées entre les cathodes des diodes ne sont plus nécessaires. Par contre il est possible que la pièce de prise de contact 4 sur une diode annulaire 9 ne soit pas rigoureusement centrée, que certaines différences de potentiels apparaissent. C'est pourquoi il est bon, mais il n'est pas obligatoire, que des fils de liaison 10 établissent l'équilibre de potentiel entre les capacités 5.

Enfin, comme dans le cas précédent, des selfs 6 formées par des rubans métalliques établissent le contact entre la première capacité 5 et la seconde capacité 7 pour chaque cellule du combineur.

Dans les deux cas de figures 4 et 5, l'énergie émise par le combineur selon l'invention est prélevée sur la couronne 7, qui constitue à la fois le boîtier, une capacité et le collecteur d'énergie, et cette énergie est utilisée, dans une charge extérieure 3.

La figure 6 représente une vue en coupe d'un combineur selon l'invention. Cette vue est valable pour le cas où une pluralité de pastilles semiconductrices sont regroupées sur une embase, et pour le cas où les dispositifs semiconducteurs sont intégrés dans une seule pastille.

Sur une embase métallique 11, qui est généralement un cylindre de cuivre ou de laiton, de façon à mieux dissiper la chaleur, sont fixées soit une pluralité de pastilles élémentaires 1, soit une unique pastille intégrée 9. Autour de ce groupement de semiconducteurs sont fixées sur l'embase métallique 11 un certain nombre de capacités 5, qui sont constituées par un pavé de matériau diélectrique portant sur deux faces opposées des métallisations 12 et 13. L'une de ces métallisations, 12 par exemple, sert à souder une capacité sur l'embase 11. L'autre métallisation, 13 par exemple, permet de recevoir les selfs 4 et 6 qui unissent les dispositifs semiconducteurs aux capacités 5 et 7.

Concentriquement aux semiconducteurs et aux capacités est fixée sur l'embase une couronne de matériau céramique 7, métallisée sur deux faces opposées, ces faces étant les faces planes de la couronne, en 14 et 15. Ceci exclu que les faces cylindriques extérieures et intérieures soient les faces métallisées car alors il y aurait court-circuit du condensateur lors de la soudure de la couronne sur l'embase 12. L'embase est adaptée pour absorber une partie des différences d'épaisseurs entre la pastille semiconductrice, les capacités 5 et la couronne 7. De toute façon, la couronne 7 doit être légèrement plus haute, vue en coupe, que les capacités 5 car c'est cette couronne qui porte le couvercle métallique 16 qui referme le boîtier et sur lequel est amenée la tension de polarisation du combineur.

La figure 7 représente une vue partielle de trois quart d'une variante du combineur selon l'invention, dans le cas où une pluralité de dispositifs semiconducters sont regroupés en une seule diode de surface équivalente et intégrés sur une seule pastille.

Il a été dit que dans ce cas la diode est avantageusement de forme annulaire car cette forme permet d'avoir un meilleur rendement et de dissiper d'avantage d'énergie, les caractéristiques thermiques de la diode étant en rapport avec le diamètre moyen de l'anneau.

Puisqu'il n'y a dans ce cas qu'une seule pastille de diode, il n'est plus nécessaire que d'avoir une seule cellule de préadaptation d'impédance, comportant une seule première capacité et une seule seconde capacité. Par conséquent la pluralité des capacités 5 qui dans les figures précédentes adaptaient une pluralité équivalente de diodes, peut être remplacée par une unique capacité 17, de forme annulaire, située entre une unique pastille de diode 9 annulaire et une unique seconde capacité 7 annulaire et ainsi le combineur prend une forme parfaitement régulière et équilibrée. La vue en coupe d'un tel combineur est également celle de la figure 6, et la vue de trois quart de la figure 7 doit être complétée, pour réaliser un combineur selon l'invention, par les métallisations nécessaires, c'est-à-dire les selfs 4 et 6 et par l'anneau de céramique 7 qui, avec un couvercle 16, forment boîtier d'encapsulation d'un dispositif selon l'invention.

Les dimensions du combineur selon l'invention permettent de le réaliser sous forme de circuit intégré, sur une pastille de silicium ou de matériau du groupe III-V tel que GaAs.

Les dispositifs semiconducteurs diodes sont réalisés selon les règles de l'art et selon le type et les caractéristiques requis pour l'application. Les capacités, surtout les capacités 5, sont réalisée sous forme de capacités MOS, et les selfs sous forme de métallisations appropriées en surface de la pastille semiconductrice. Il est alors préférable de conserver la seconde capacité 7 sous forme d'une couronne en matériau diélectrique qui concourt à former le micro-boîtier d'encapsulation du circuit intégré.

Le combineur selon l'invention se présente comme un élément cylindrique de cuivre ou de laiton, comportant sur l'une de ses extrémités un micro-boîtier d'adaptation dont le couvercle métallique 16 sert à amener la polarisation. Cet élément est étanche et il peut être monté dans différents dispositifs tels que des guides d'onde ou des montages Kurokawa.

Un tel combineur est utilisé dans les montages oscillateurs ou amplificateurs, pour les matériels de télécommunication, de radars ou de radioguidage.

**Revendications**

1. Combineur compact de dispositifs semiconducteurs, fonctionnant en hyperfréquences, comportant, fixés sur une embase métallique (11), au moins une pastille semiconductrice (1) et au moins une cellule de préadaptation d'impédance formée par deux selfs ($L_1$, $L_2$) en série et deux capacités ($C_1$, $C_2$) en parallèle, chaque capacité étant connectée entre une self et la masse, ce combineur étant caractérisé en ce que:

- la première capacité ($C_1$) de chaque cellule de préadaptation d'impédance est un élément localisé (5), en pavé, fixé sur l'embase (11),
- la seconde capacité ($C_2$), commune à toutes les cellules de préadaptation d'impédance, est un élément localisé, formé par une couronne (7), en matériau diélectrique, métallisée sur deux faces planes opposées (14, 15), fixée sur l'embase (11) et concentrique au combineur, ladite couronne (7) formant boîtier d'encapsulation,
- les selfs (4, 6) sont en éléments non localisés, formées par des rubans métalliques thermocomprimés entre une pastille (1) et la première capacité (5) pour la première self (4), entre la première (5) et la seconde capacité (7) pour la seconde self (6).

2. Combineur compact selon la revendication 1, caractérisé en ce qu'il combine l'énergie d'une pluralité de diodes (1), en pastilles élémentaires.

3. Combineur compact selon la revendication 1, caractérisé en ce qu'une pluralité de diodes sont intégrées en une pastille unique (9), sous forme annulaire, de surface équivalente à la surface de la pluralité de diodes.

4. Combineur compact selon la revendication 1, caractérisé en ce que des résistances d'équilibrage (8) sont connectées entre les premières capacités (5) de chaque cellule d'adaptation d'impedance.

5. Combineur compact selon la revendication 4, caractérisé en ce que des selfs d'équilibrage (10) sont connectées entre les premières capacités (5) de chaque cellule d'adaptation d'impédance.

6. Combineur compact selon la revendication 3, caractérisé en ce qu'une pluralité de premières capacités (5) sont intégrées en une unique capacité (17) de forme annulaire.

7. Combineur compact selon la revendication 1, caractérisé en ce que la seconde capacité (7), en couronne, soudée sur l'embase (11), forme boîtier d'encapsulation du combineur, et reçoit un couvercle métallique (16) par lequel est amenée la tension de polarisation.

8. Combineur compact selon la revendication 1, caractérisé en ce qu'il est réalisé sous forme intégrée sur une pastille de matériau semiconducteur, les capacités (5, 7) étant des capacités MOS (métal-oxyde-semiconducteur) et les selfs (4, 6) étant des métallisations en surface de la pastille monolithique.

**Patentansprüche**

1. Kompakte, im Höchstfrequenzbereich arbeitende Kombiniereinrichtung für Halbleitereinrichtungen bei der auf einem Metallsockel (11) befestigt sind: wenigstens ein Halbleiterplättchen (1) und wenigstens eine Impedanzvoranpassungszelle, die aus zwei in Reihe geschalteten Drosseln ($L_1$, $L_2$) und aus zwei parallel geschalteten Kapazitäten ($C_1$, $C_2$) besteht, wobei jede Kapazität zwischen einer Drossel und der Masse angeschlossen ist, dadurch gekennzeichnet, daß:
- die erste Kapazität ($C_1$) jeder Impedanzvoranpassungszelle ein konzentriertes, blockförmiges Element (5) ist, das auf dem Sockel (11) befestigt ist,
- die zweite, allen Impedanzvoranpassungszellen gemeinsame Kapazität ($C_2$), ein konzentriertes Element ist, das von einem aus einem dielektrischen Material bestehenden Kranz (7) gebildet ist, auf zwei ebenen und entgegengesetzten Flächen (14, 15) metallisiert ist, auf dem Sockel (11) befestigt ist und in Bezug auf die Kombiniereinrichtung konzentrisch ist, wobei der obengenannte Kranz ein Einkapselungsgehäuse bildet,
- die Drosseln (4, 6) aus nicht konzentrierten Elementen bestehen, von Metallstreifen gebildet, welche zwischen einem Plättchen (1) und der ersten Kapazität (5) thermokomprimiert sind, was die erste Drossel (4) anbetrifft, bzw. zwischen der ersten (5) und der zweiten Kapazität (7), was die zweite Drossel (6) anbetrifft.

2. Kompakte Kombiniereinrichtung nach Anspruch 1, dadurch gekennzeichnet, daß sie die Energie einer Mehrzahl von Dioden (1) in Elementarplättchen kombiniert.

3. Kompakte Kombiniereinrichtung nach Anspruch 1, dadurch gekennzeichnet, daß eine Mehrzahl von Dioden in einem einzigen Plättchen (9) kombiniert ist, das ringförmig ist und dessen Oberfläche derjenigen der Dioden entspricht.

4. Kompakte Kombiniereinrichtung nach Anspruch 1, dadurch gekennzeichnet, daß Abgleichwiderstände (8) zwischen den ersten Kapazitäten (5) jeder Impedanzvoranpassungszelle angeschlossen sind.

5. Kompakte Kombiniereinrichtung nach Anspruch 4, dadurch gekennzeichnet, daß Abgleichdrosseln (10) zwischen den ersten Kapazitäten (5) jeder Impedanzvoranpassungszelle angeschlossen sind.

6. Kompakte Kombiniereinrichtung nach Anspruch 3, dadurch gekennzeichnet, daß eine Mehrheit von ersten Kapazitäten (5) in einer einzigen, ringförmigen Kapazität (17) integriert ist.

7. Kompakte Kombiniereinrichtung nach Anspruch 1, dadurch gekennzeichnet, daß die zweite, kranzförmige Kapazität (7) auf dem Sockel (11) angelötet ist, ein Einkapselungsgehäuse der Kombiniereinrichtung bildet und einen Metalldeckel (16) empfängt, durch welchen die Polarisationsspannung geleitet wird.

8. Kompakte Kombiniereinrichtung nach Anspruch 1, dadurch gekennzeichnet, daß sie integriert auf einem Plättchen aus Halbleitermaterial verwirklicht ist, wobei die Kapazitäten (5, 7) MOS-(Metall-Oxid-Halbleiter) Kapazitäten sind und wobei die Drossel (4, 6) Oberflächemetallisierungen des monolithischen Plättchen sind.

## Claims

1. A compact semiconductor device combining means adapted to function at ultra high frequencies, comprising, secured to a metallic mount (11) at least one semiconductor wafer (1) and at least one impedance preadaptation cell formed by two chokes ($L_1$ and $L_2$) in series and two capacitors ($C_1$ and $C_2$) in parallel, each capacitor being connected between one choke and ground, said combining means being characterized in that:
- the first capacitor ($C_1$) of each impedance preadaption cell is a localized element (5) with a cobbled structure secured to the mount (11),
- the second capacitor ($C_2$), common to all the impedance preadaptation cells, is a localized element formed by a crown (7) of dielectric material, metallized on two opposite plane surfaces (14 and 15), secured to the mount (11) and concentric to the combining means, the said crown (7) forming an encapsulating casing, and
- the chokes (4 and 6) are non localized elements formed by thermocompressed metallic tapes thermocompressed between one wafer (1) and the first capacitor (5) for the first choke (4) and between the first capacitor (5) and the second capacitor (7) for the second choke (6).

2. The compact combining means as claimed in claim 1 characterized in that it combines the energy of a plurality of diodes (1), same being in the form of elementary wafers.

3. The compact combining means as claimed in claim 1 characterized in that a plurality of diodes are integrated in a single wafer (9) in an annular form and with an area equivalent to the area of the plurality of diodes.

4. The compact combining means as claimed in claim 1 characterized in that balancing resistors (8) are connected between the first capacitors (5) of each impedance adaptation cell.

5. The compact combining means as claimed in claim 4 characterized in that balancing chokes (10) are connected between the first capacitors (5) of each impedance adaption cell.

6. The compact combining means as claimed in claim 3 characterized in that the a plurality of first capacitors (5) are integrated in a single capacitor (17) with an annular form.

7. The compact combining means as claimed in claim 1 characterized in that the second capacitor (7) in the form of a crown and soldered to the mount (11), forms an encapsulating casing of the combining means and has a metallic cover (16) through which the polarizing voltage is supplied.

8. The compact combining means as claimed in claim 1 characterized in that it is implemented in an integrated from of a wafer of semiconductor material, the capacitors (5 and 7) being MOS (metal oxide semiconductor) capacitors and the chokes (4 and 6) being metallisations on the surface of the monolithic wafer.

0 161 166

FIG_1

FIG_2

FIG_3

FIG_4

0 161 166

FIG_5

3

# FIG_6

# FIG_7